Europäisches Patentamt

European Patent Office

Office européen des brevets

(11) Numéro de publication: **0 313 121**
**A1**

# (12) DEMANDE DE BREVET EUROPEEN

(21) Numéro de dépôt: **88201995.3**

(22) Date de dépôt: **14.09.88**

(51) Int. Cl.⁴: **H03J 7/02**

(30) Priorité: **22.09.87 FR 8713061**

(43) Date de publication de la demande:
**26.04.89 Bulletin 89/17**

(84) Etats contractants désignés:
**DE FR GB IT**

(71) Demandeur: **LA RADIOTECHNIQUE PORTENSEIGNE**
**51, rue Carnot**
**F-92150 Suresnes(FR)**

(84) **FR**

(71) Demandeur: **N.V. Philips' Gloeilampenfabrieken**
**Groenewoudseweg 1**
**NL-5621 BA Eindhoven(NL)**

(84) **DE GB IT**

(72) Inventeur: **Vilard, Philippe Société Civile S.P.I.D.**
**209, rue de l'Université**
**F-75007 Paris(FR)**

(74) Mandataire: **Caron, Jean et al**
**SOCIETE CIVILE S.P.I.D. 209, rue de l'Université**
**F-75007 Paris(FR)**

(54) Procédé et dispositif pour accorder un circuit résonnant.

(57) Dispositif automatique de réglage : un oscillateur (9) suivi d'un inverseur (11) alimente le circuit résonnant (16), suivi d'un discriminateur de fréquence (15). Le circuit (16) est par exemple le circuit cloche d'une platine de décodage SECAM. Le discriminateur fait alors partie du téléviseur. Une source de synchronisation (10) fournit des signaux de ligne et de trame et un signal d'identification de couleur à un générateur de tops et de fenêtres (12). Ce dernier fournit à l'inverseur un signal déclenchant l'inversion du signal issu de l'oscillateur, ce qui provoque un saut de phase de 180°. Il fournit aussi à un circuit de mesure et de traitement (13) une fenêtre de temps qui sert à la mesure en sortie du discriminateur du signal transitoire produit par le saut de phase. Le résultat de la mesure est fourni à un élément (14) qui agit sur le réglage du circuit résonnant (16).

FIG. 6

## PROCEDE ET DISPOSITIF POUR ACCORDER UN CIRCUIT RESONNANT

L'invention concerne un procédé et un dispositif pour accorder un circuit résonnant. Ce procédé et ce dispositif peuvent être employés en télévision, et notamment pour le réglage de l'accord du circuit "cloche" d'un récepteur de télévision de type SECAM.

Pour le réglage d'un tel circuit lors de la fabrication du téléviseur, plusieurs méthodes peuvent être employées.

On utilise par exemple un système mesurant le courant entrant dans le circuit et la tension à ses bornes, et le réglage est correct lorsque ces deux grandeurs sont en phase à la fréquence nominale. La phase est comparée sur l'écran d'un oscilloscope et le réglage réalisé à la main. La mise en oeuvre d'une automatisation du réglage serait difficile parce que la mesure très précise de la différence de phase n'est pas simple.

On peut aussi utiliser, pour déterminer l'action de réglage à entreprendre afin d'accorder le circuit, un signal produit par un discriminateur de fréquence qui est branché en aval du circuit, et exciter de manière répétitive le circuit successivement de deux manières différentes. Un procédé de ce genre est décrit par le document DE-0S-2 702 565, qui enseigne d'observer sur l'écran d'un oscilloscope le signal issu du discriminateur alors que le circuit est excité successivement par des fréquences placées symétriquement par rapport à la fréquence nominale du circuit cloche, afin de régler manuellement ce circuit.

L'invention fournit un procédé qui est beaucoup plus précis et plus facile à automatiser et qui, de ce fait, permet la réalisation d'un dispositif installé dans chaque téléviseur et capable d'assurer automatiquement le réglage du circuit cloche à l'intérieur même du téléviseur. Un tel dispositif est avantageux lorsque le circuit cloche est un circuit intégré du type à capacités commutées.

Le procédé selon l'invention est notamment remarquable en ce que c'est l'amplitude du signal transitoire produit par le discriminateur immédiatement après le passage de la première à la seconde manière d'exciter le circuit qui est utilisée pour déterminer l'action de réglage, le circuit étant à chaque répétition d'abord excité par un signal dont la fréquence est la fréquence nominale d'accord.

Ainsi, ce procédé ne requiert la fourniture que d'une seule fréquence, et c'est une amplitude, facile à mesurer, qui est la grandeur déterminante pour le réglage.

Dans une variante simple, le signal répétitif est brusquement supprimé à un instant déterminé au cours de chaque répétition.

Selon une autre variante, on obtient une meilleure sensibilité lorsque la phase du signal répétitif est brusquement inversée de 180°, au moins une fois au cours de chaque répétition.

En outre on peut éliminer l'influence d'un déréglage éventuel du discriminateur de fréquences, en échantillonnant le signal produit par ce discriminateur à deux instants dont l'un correspond à un régime établi d'excitation à la fréquence nominale et l'autre suit immédiatement le passage de la première manière à la deuxième, et en utilisant la différence entre les deux échantillons pour déterminer l'action de réglage.

Un dispositif selon l'invention, notamment la platine de décodage d'un téléviseur de type SECAM, muni d'un circuit résonnant ajustable au moyen de capacités commutables, et d'au moins un discriminateur de fréquences branché en aval du circuit résonnant est remarquable en ce qu'il comporte :
- un générateur qui fournit un signal à la fréquence nominale désirée pour le circuit résonnant et y introduit à un premier instant une modification brutale,
- un agencement de synchronisation déterminant ledit premier instant, ainsi qu'un deuxième instant suivant rapidement le premier,
- des moyens pour remplacer, pendant une durée qui comprend ledit premier instant, un signal appliqué au circuit résonnant (qui dans le cas d'une platine SECAM est le circuit cloche) par le signal issu du générateur,
- des moyens pour échantillonner au deuxième instant le signal sortant du discriminateur, et pour le mettre en forme afin de fournir un signal d'erreur fonction de l'amplitude du signal échantillonné,
- et des moyens pour commander la commutation des capacités en fonction du signal d'erreur.

De préférence l'agencement de synchronisation indique ledit premier instant une fois pendant chaque retour de trame.

Le dispositif selon l'invention permet d'économiser l'étape de réglage du circuit résonnant lors de la fabrication du téléviseur, et en outre il assure que le réglage de ce circuit restera parfait tout au long de la vie du téléviseur.

Avantageusement le générateur est constitué d'un oscillateur à boucle d'asservissement de fréquence basé sur la fréquence de ligne, ce qui permet d'obtenir économiquement une stabilité parfaite.

Les moyens pour commander la commutation des capacités sont avantageusement constitués d'une mémoire dont le contenu est, soit incrémenté ou décrémenté à chaque échantillonnage selon le signe du signal issu du discriminateur, soit laissé intact si la valeur absolue de ce signal est inférieure à une quantité prédéterminée, et, le contenu de la mémoire étant exprimé en numérotation binaire, chacun de ses bits commande la commutation d'une des capacités.

La description qui va suivre, en regard des dessins annexés décrivant des exemples non limitatifs fera bien comprendre comment l'invention peut être réalisée.

la figure 1 représente, à titre d'exemple de circuit résonnant, le circuit cloche d'un téléviseur SECAM.

Les figures 2, 3, 4 sont des diagrammes montrant l'évolution au cours du temps de divers signaux rencontrés dans le dispositif.

La figure 5 est un diagramme illustrant la sensibilité du procédé.

La figure 6 représente un dispositif pour mettre en oeuvre le procédé selon l'invention, lors d'un réglage en fabrication.

La figure 7 représente une platine de décodage SECAM munie des moyens de l'invention.

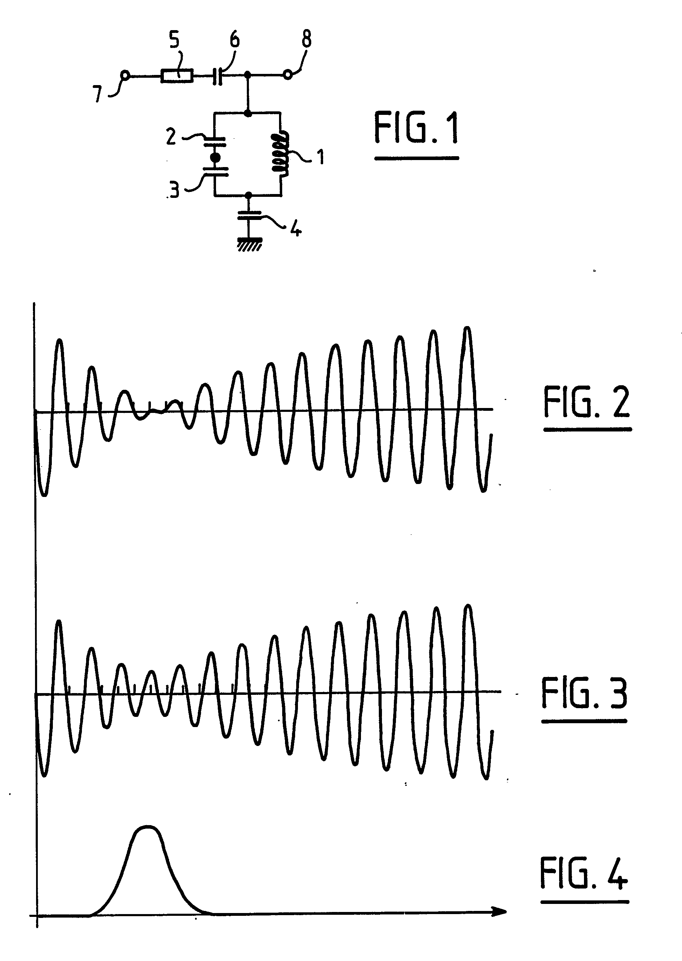

Le circuit cloche de la figure 1 est actuellement employé dans la fabrication de téléviseurs. Il comporte un circuit résonnant proprement dit constitué de l'inductance 1 en parallèle avec des capacités d'accord 2, 3. Il y a deux capacités 2, 3 afin de constituer un diviseur capacitif permettant de mesurer la tension sans que la capacité de la sonde de mesure ne dérègle le circuit. Entre l'entrée 7 et le circuit est placée une résistance 5 et un condensateur d'isolement 6. Le signal de sortie est présent sur la borne 8, reliée au circuit résonant. Le condensateur 4 ne sert qu'à l'isolation galvanique.

L'invention permet en outre d'économiser le condensateur 3, puisqu'on n'a pas besoin de mesurer la tension au niveau du circuit lui-même.

Le principe sur lequel se fonde le procédé selon l'invention est de modifier brusquement la manière d'exciter le circuit pour que, lors du passage de la première à la deuxième manière, le circuit passe par une phase transitoire de "roue libre" où ses caractéristiques propres s'expriment pendant un bref instant : si le circuit déréglé (c'est à dire que sa fréquence propre est différente de la fréquence nominale) est excité à la fréquence nominale, et qu'il se présente une discontinuité dans la manière de l'exciter, la fréquence d'oscillation avant la discontinuité est bien évidemment la fréquence nominale, et il en est de même un certain temps après la discontinuité, mais entre les deux le circuit réagit d'une manière spécifique qui dépend de sa fréquence propre et de sa surtension.

Les figures 2 et 3 illustrent ce phénomène. Elles représentent le résultat de la simulation sur ordinateur d'un circuit résonant dont la surtension est de seize, comme celle d'un circuit cloche. A l'origine des abscisses, la phase de la tension d'excitation en est brusquement changée de 180°, c'est-à-dire que le signal est inversé. Pour la figure 2, l'excitation se fait à la fréquence d'accord et, pour la figure 3, l'excitation se fait à 0.99 fois la fréquence propre du circuit.

Dans le premier cas (figure 2), pendant la phase de "roue libre", l'amplitude décroît, s'annule, puis croit pour retrouver son niveau initial. Comme la fréquence initiale était la fréquence propre de résonance de circuit, elle n'a aucune raison de varier et les passages à zéro de l'onde se font régulièrement aux mêmes instants que si rien n'avait changé dans la manière d'exciter le circuit.

Dans le second cas (figure 3) l'amplitude diminue mais ne s'annule pas. La fréquence tend à se déplacer dans un sens qui dépend du signe de la différence entre la fréquence d'excitation et la fréquence propre, c'est-à-dire ici à augmenter, et les passages à zéro se font plus tôt que dans le cas précédent. En fin de compte on a "perdu" une demi-période et le signal se retrouve en phase avec la nouvelle tension d'excitation (dont la fréquence est toujours de 0.99 fois la fréquence propre).

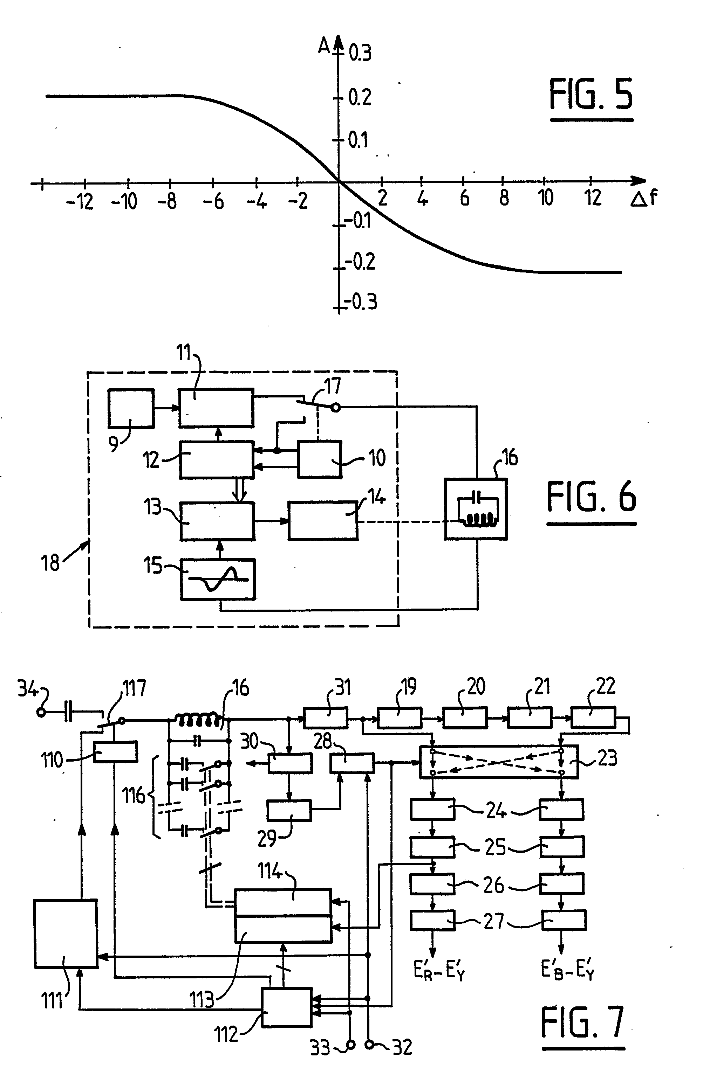

Comme la fréquence varie et qu'en outre l'amplitude n'est pas nulle, un discriminateur de fréquence qui est branché en aval du circuit cloche délivre donc un signal, qui est représenté sur la figure 4. Dans le cas de la figure 2, en supposant que ce discriminateur soit réglé symétriquement par rapport à la fréquence nominale, il ne délivre aucun signal.

Bien entendu, si la fréquence de départ est plus haute que la fréquence du circuit, la dérive transitoire a lieu dans l'autre sens, et le signal issu du discriminatuer est de signe contraire : ce signal permet donc de déterminer dans quel sens il faut agir pour obtenir l'accord du circuit.

La figure 5 illustre la sensibilité obtenue grâce à la méthode décrite ci-dessus. En ordonnée est l'amplitude (en volts) de l'impulsion de la figure 4, en abscisse le désaccord de fréquence en kHz. Cette courbe a été obtenue en modifiant pas à pas la fréquence du signal d'excitation et en mesurant à chaque fois la tension crête de l'impulsion. On constate que l'amplitude maximale est déjà pratiquement atteinte pour un écart de fréquence de 6 à 8 kHz, alors que la tolérance habituelle de réglage d'un circuit cloche est de ± 40 kHz. La méthode procure donc une sensibilité exceptionnellement favorable : on a mesuré que pour un déréglage $\Delta f$ = 5 kHz, on a une variation de fréquence qui fournit transitoirement la même amplitude en sortie du discriminateur, qu'un écart permanent de 400 kHz. L'accroissement de sensibilité est de 80/1.

Le changement d'excitation est bien entendu répétitif, de façon à faciliter la mesure de l'effet produit. Dans un appareillage de contrôle et/ou de réglage d'un circuit cloche, une onde à 4,286 MHz est introduite dans le circuit cloche, cette onde présentant un saut de phase de 180°, une fois au cours de chaque ligne de balayage de l'image de télévision. Dans certains modèles de téléviseurs, le signal issu du discriminateur a un niveau continu différent une ligne sur deux, et de plus, de signe opposé. Il faut donc mesurer l'effet produit une ligne sur deux seulement. On peut noter, bien que ceci ne puisse servir à une mécanisation du réglage, que l'effet visuel produit sur l'écran du téléviseur est intéressant et peut servir pour un réglage manuel. Si l'accord est parfait l'écran est uniformément magenta. En cas de désaccord apparaît une barre verticale correspondant au saut de phase, qui est de couleur bleue ou rouge suivant le sens du désaccord. Ce procédé est extrêmement sensible, puisqu'une telle barre apparaît déjà bien avant que le déréglage ne dépasse les normes en vigueur. Afin de créer une mire utilisable pour régler dans une tolérance prédéfinie (par exemple 4,286 MHz ± 40 kHz) on peut envoyer les deux fréquences limites (ici 4,246 et 4,326 MHz) multiplexées sur quelques lignes, avec une cassure de phase à un instant de la ligne, différent pour chacune de ces fréquences. Si le circuit est dans la tolérance, on observe alors sur l'écran deux barres de couleurs différentes, et hors tolérance, deux bandes de même couleur (rouges ou bleues selon le sens du déréglage).

Au lieu d'inverser le signal, on peut aussi le supprimer brusquement : pendant la phase de décroissance amortie du signal dans le circuit, la fréquence glisse vers sa valeur nominale, avant que le signal ne s'annule. On peut aussi le supprimer seulement pendant une fenêtre de temps pour le rétablir ensuite, avec sa phase initiale, ce qui procure deux glissements de fréquence opposés successifs. Toutefois c'est la méthode avec saut de phase de 180° procure une sensibilité très supérieure avec une beaucoup plus grande facilité d'exploitation du signal issu du discriminateur.

Dans le dispositif automatique de réglage d'un circuit résonnant représenté à la figure 6, un oscillateur 9 suivi d'un inverseur 11 alimente le circuit résonnant 16, suivi du discriminateur de fréquence 15. Si le circuit 16 est le circuit cloche d'une platine de décodage SECAM, le discriminateur 15 fait déjà partie du téléviseur. La source de synchronisation 10 fournit des signaux de ligne et de trame et un signal d'identification de couleur à un générateur de tops et de fenêtres 12. Ce dernier fournit à l'inverseur le signal déclenchant le saut de phase de 180°. Il fournit aussi à un circuit de mesure et de traitement 13 deux fenêtres de temps qui servent à la mesure du signal transitoire. Le résultat du circuit de mesure 13 est fourni à un élément 14. Dans le cas d'un dispositif de réglage en atelier, cet élément est une chaine de pilotage actionnant mécaniquement le réglage du circuit résonnant 16. Dans le cas d'un dispositif de réglage incorporé dans un téléviseur avec un circuit cloche comportant un réseau de capacités commutées par des interrupteurs intégrés, l'élément 14 est un dispositif de logique électronique, qui commande l'ouverture ou la fermeture d'interrupteurs électroniques mettant hors service ou en service certaines des capacités du filtre.

Les éléments de ce dispositif sont facilement réalisables par l'homme du métier, pour satisfaire des fonctions qui sont les suivantes, dans le cas d'un appareil de réglage en atelier :
. oscillateur 9 : il est par exemple obtenu au moyen d'un oscillateur à quartz, de préférence à la fréquence double de la fréquence nominale, soit 8,572 MHz.
. inverseur 11 : c'est par exemple une bascule divisant par deux le signal à 8,572 MHz, qui délivre deux signaux opposés sur deux sorties. Chacune de ces sorties est reliée au circuit cloche par une porte et une seule de ces deux portes est ouverte à la fois. Le signal du générateur de tops 12 fait changer de porte. On pourrait aussi faire que, lorsque la bascule divisant par 2 le signal de l'oscillateur reçoit le signal du générateur de top 12, elle soit inhibée durant une période et de ce fait introduise un saut de phase de 180° dans le signal sortant. Ce dernier est un signal carré, ce qui n'a pas d'importance, les harmoniques étant filtrées par le circuit résonnant. En sortie est prévu un commutateur 17 dont le rôle est de fournir le signal seulement pendant les phases d'aller de balayage ligne. Durant les retours ce sont les signaux de synchronisation et les salves d'identification habituels qui sont fournis en provenance de la :
. source de synchronisation 10 qui peut être éventuellement tirée d'un générateur de mire existant.
. générateur de fenêtres 12 : celui-ci fournit différents signaux à partir des signaux de synchronisation ligne. Il fournit à l'inverseur 11 un top, par exemple environ 15 µs après le début d'une ligne. Il fournit au circuit de mesure 13 une fenêtre de mesure qui commence environ 1 µs après le top précité et dure environ 3 µs, et une deuxième fenêtre de durée identique, située par exemple 10 à 20 µs après la première. Ces fenêtres ne sont fournies qu'une ligne sur deux, durant un type de ligne prédéterminé (rouge ou bleu) le choix étant piloté par un signal d'identification de couleur issu du générateur 10. Ce dernier fournit en outre la fenêtre de commande du commutateur 17 à la sortie de l'inverseur. Des circuits fournissant de tels signaux notamment à partir de divisions successives d'un signal d'horloge et des tops de synchro-ligne sont de réalisation facile.

. Circuit de mesure 13 : le signal transitoire issu du discriminateur 15 peut présenter une polarité et une amplitude variables selon le réglage du discriminateur, les caractéristiques des circuits, le type de ligne (bleu/rouge). Pour éliminer ces effets, le générateur 12 ne fournit les fenêtres de mesure, comme expliqué plus haut, que durant des lignes prédéfinies. En outre le signal est superposé à un. signal continu qui dépend lui aussi des mêmes paramètres. Pour éliminer l'effet du signal continu, on utilise les deux fenêtres successives décrites ci-dessus à propos du générateur 12. La valeur fournie par le discriminateur est enregistrée (par exemple de façon analogique, en chargeant un condensateur proportionnellement à cette valeur) durant chacune de ces deux fenêtres (chaque fois dans un condensateur différent) à la suite de quoi la différence entre ces deux valeurs est détectée au moyen d'un montage différentiel et fournie à l'élément 14 de pilotage du réglage.

Le cas de la platine de décodage SECAM représentée à la figure 7, munie d'un circuit cloche 16 à capacités commutées, est particulièrement intéressant du fait qu'elle comporte déjà un discriminateur, et que le téléviseur dont elle fait partie comporte déjà une source de synchronisation, qui vont être utilisés dans le dispositif. Les éléments suivants sont employés :

La source de synchronisation du téléviseur fournit sur les entrées 32, 33 les tops de ligne et de trame, respectivement.

Les éléments référencés 19 à 31 sont les constituants habituels connus d'une platine de décodage : le vidéo-signal composite élaboré dans les parties ad-hoc (non représentées) du téléviseur est amené à la borne 34. Via un condensateur, puis l'interrupteur 117 dont le rôle sera décrit plus loin, puis le circuit cloche 16, il est amené à l'amplificateur limiteur 31, à la sortie duquel il est aiguillé sur deux directions. L'une va directement à une voie du permutateur 23. L'autre va à l'autre voie, via un adaptateur d'impédance 19, une ligne de retard 20, un autre adaptateur 21, et un amplificateur compensateur 22. A chaque sortie du permutateur on trouve en cascade un limiteur 24, un discriminateur de fréquences 25, un circuit de désaccentuation 26, et un étage de sortie 27. Le signal est aussi amené au portier 30, lié au circuit d'identification 29 qui pilote le circuit bistable 28 actionné par les tops de ligne 32, et qui commande le permutateur 23. Tout cet ensemble connu est représenté ici seulement pour bien faire comprendre comment les éléments 110 à 117 de l'invention y sont connectés. On emploie aussi des arrangements de circuits, différents de celui représenté : ils comportent évidemment aussi une entrée de signal, une sortie de discriminateur et des tops de synchronisation, et il est donc facile d'y adapter l'invention de façon équivalente.

Les tops de synchronisation-trame 33 sont utilisés pour déclencher un processus de réglage à chaque retour de trame, pendant une ou plusieurs lignes. On pourrait aussi prévoir un processus à chaque mise en service du téléviseur, mais il est plus simple d'éviter une procédure spéciale au démarrage, et en outre le réglage à chaque trame est préférable dans le cas où une dérive du filtre se manifesterait après la mise en service.

Le générateur 111 est constitué, dans un téléviseur à circuits au moins partiellement numériques, à partir d'une horloge interne présente dans un tel téléviseur. Un circuit connu dit P.L.L. (Phase Locked Loop) fournit une fréquence multiple de la fréquence ligne $f_L$. Un multiple de 274 fois donne la fréquence 4.28125 MHz, qui est à 4.75 kHz de la fréquence désirée. Comme la tolérance habituelle est de 40 kHz et que la sensibilité de la méthode est très grande, cette fréquence de 274 x $f_L$ peut convenir. Si l'on veut plus de précision, on peut créer la fréquence 1646 x $f_L$, puis la diviser par six (diviser par 3 puis diviser par 2 pour obtenir un rapport cyclique de 1) l'erreur étant alors inférieure à 500 Hz, ou aussi créer 2743 x $f_L$ et diviser par 5 puis 2 (erreur : 62,5hz !).

Ce générateur 111 comporte en outre un inverseur semblable à celui 11 décrit plus haut, pour insérer un changement de phase au cours d'une ligne. C'est la bascule de cet inverseur qui réalise la dernière division de fréquence par deux.

L'agencement de synchronisation 112 fournit un signal de commande qui dure un temps de ligne ou une fraction d'un temps de ligne au cours du retour de trame, et est amené au commutateur 110, 117 qui a pour fonction de remplacer, pendant la durée du signal de commande, le signal 34 par le signal issu du générateur 111. (Bien entendu le commutateur est électronique).

Le signal de commande est déclenché à partir du top de retour trame. La sortie de la bascule 28 qui commande le permutateur est aussi amenée au générateur de temps 112 pour lui permettre de choisir à chaque retour de trame une ligne de la même couleur.

A un premier instant compris dans la durée de ligne ci-dessus, un top est fourni par l'agencement de synchronisation 112 au générateur 111, afin d'y déclencher une modification brutale, à savoir un changement de phase de 180°, par inversion du signal. Le générateur 112 fournit enfin au circuit d'échantillonnage et de traitement 113, à un deuxième instant suivant le premier d'environ 1µs, une fenêtre de mesure qui dure environ 3µs, et à un troisième instant, situé par exemple 10 à 20µs après le second, une deuxième fenêtre de durée identique (tout ceci comme dans le cas du dispositif de réglage en fabrication). Le deuxième instant suit rapidement le premier, de façon à correspondre à la période de "roue libre" du circuit résonnant, et le troisième instant correspond à un régime établi c'est-à-dire arrive soit avant les deux premiers, soit suffisamment tard après eux pour que le circuit résonnant soit revenu à une excitation stable.

Le circuit 113 d'échantillonnage est relié à la sortie d'un discriminateur 26 et remplit les mêmes fonctions que celui 13 de la figure 6. Toutefois, la présence de deux condensateurs de mémorisation de valeurs analogiques peut être gênante dans le cas d'une réalisation en circuits intégrés. On utilisera alors deux convertisseurs analogiques/numériques. Ces derniers sont très simples à réaliser : du fait que lorsqu'on atteint là précision de réglage désirée, l'amplitude de l'impulsion transitoire est encore relativement importante, il suffit que les deux valeurs échantillonnées lors des deux fenêtres soient comparées grossièrement. Les convertisseurs peuvent donc être des dispositifs à quelques bits seulement. En outre, comme la durée de l'impulsion transitoire est de l'ordre de la microseconde, ils n'ont pas besoin d'être rapides. On peut les réaliser en définissant un petit nombre de seuils discrets et en comparant le signal à chacun de ces seuils au moyen de plusieurs comparateurs ou d'un comparateur dont l'entrée de référence est aiguillée tour à tour sur chacun de ces seuils. Au moins celui qui correspond à la première fenêtre de temps est suivi d'un latch pour conserver la valeur de l'échantillon jusqu'au moment de la deuxième fenêtre de temps où les valeurs des deux échantillons sont comparées.

Le circuit cloche 16 comporte un certain nombre de capacités commutables 116. On peut choisir une valeur assez élevée pour l'inductance, de manière à réduire la valeur des capacités, qui alors peuvent être intégrées, ainsi que les commutateurs. Avec une capacité totale d'environ 160pF et une amplitude de réglage de 10%, l'ensemble 116 des capacités commutables vaut environ 15pF. Elles sont réparties par exemple en quatre unités valant respectivement 1, 2, 4, 8 pF, ce qui permet un réglage à 1pF près, soit 0,6% de la capacité totale, ce qui donne 0,3% en fréquence, ou environ 13 kHz.

Le circuit de commande 114 des interrupteurs électroniques est constitué d'un compteur/décompteur jusqu'à 16, donc à quatre bits. Ce compteur/décompteur est incrémenté ou décrémenté d'une unité à chaque retour de trame, selon le signe de la tension obtenue par la comparaison entre les deux échantillons prélevés à la sortie du discriminateur. Si toutefois cette tension est inférieure en valeur absolue à une quantité prédéterminée qui correspond à la limite accordée pour la précision du réglage, 13 kHz par exemple avec les ca pacités décrites ci-dessus, le compteur n'est pas actionné. Tant qu'il n'est pas actionné, il se comporte comme une mémoire conservant la valeur de comptage. Alors il suffit de commander les commutateurs de capacités 116 chacun par un des bits du compteur pour obtenir un réglage correct de la fréquence du circuit cloche au bout de quelques trames. Bien entendu la capacité la plus grande est reliée au bit de poids fort, et ainsi de suite.

Tous les éléments ci-dessus peuvent être réalisés facilement par l'homme du métier à partir de circuits logiques de base, et peuvent en outre être facilement intégrés dans un circuit monolithique.

Le procédé selon l'invention peut aussi être utilisé pour le réglage de tout filtre dont le comportement transitoire est semblable à celui d'un circuit cloche, c'est à dire en général au moins pour les filtres à bandes latérales symétriques. Pour ce qui est du dispositif incorporé à action périodique, il peut aussi être utilisé pour tout filtre, à condition qu'il soit permis de remplacer périodiquement le signal utile par le signal spécial de réglage.

## Revendications

1. Procédé pour accorder un circuit résonnant, selon lequel on utilise, pour déterminer l'action de réglage à entreprendre afin d'accorder le circuit, un signal produit par un discriminateur de fréquence qui est branché en aval du circuit, et on excite de manière répétitive le circuit successivement de deux manières différentes, caractérisé en ce que c'est l'amplitude du signal transitoire produit par le discriminateur immédiatement après le passage de la première à la seconde manière d'exciter le circuit qui est utilisée pour déterminer l'action de réglage, et en ce que le circuit est à chaque répétition d'abord excité par un signal dont la fréquence est la fréquence nominale d'accord.

2. Procédé selon la revendication 1, caractérisé en ce que le signal répétitif est brusquement supprimé à un instant déterminé, au cours de chaque répétition.

3. Procédé selon la revendication 1, caractérisé en ce que la phase du signal répétitif est brusquement inversée de 180°, au moins une fois au cours de chaque répétition.

4. Procédé selon l'une quelconque des revendications 1 à 3, caractérisé en ce que l'on échantillonne le signal produit par le discriminateur de fréquences à deux instants dont l'un correspond à un régime établi d'excitation à la fréquence nominale et l'autre suit immédiatement le passage de la première manière à la deuxième, et en ce que c'est la différence entre les deux échantillons qui fournit le signal déterminant l'action de réglage.

5. Dispositif, muni d'un circuit résonnant ajustable et d'au moins un discriminateur de fréquences branché en aval du circuit résonnant, caractérisé en ce qu'il comporte :

- un générateur qui fournit un signal à la fréquence nominale désirée pour le circuit résonnant et y introduit à un premier instant une modification brutale,

- un agencement de synchronisation déterminant ledit premier instant, ainsi qu'un deuxième instant suivant rapidement le premier,

- des moyens pour remplacer, pendant une durée qui comprend ledit premier instant, un signal appliqué au circuit résonnant par le signal issu du générateur,

- des moyens pour échantillonner au deuxième instant le signal sortant du discriminateur, et pour le mettre en forme afin de fournir un signal d'erreur fonction de l'amplitude du signal échantillonné,

- et des moyens pour ajuster le circuit résonnant en fonction du signal d'erreur.

6. Dispositif selon la revendication 5, caractérisé en ce que ledit générateur est muni d'un étage fournisssant sur deux sorties des signaux en opposition de phase et d'un commutateur pour changer, audit premier instant, la sortie sur laquelle est prélevé le signal.

7. Dispositif selon la revendication 5 incorporé dans un téléviseur, caractérisé en ce que le générateur est constitué d'un oscillateur à boucle d'asservissement de fréquence basé sur la fréquence de ligne.

8. Dispositif selon l'une quelconque des revendications 5 à 7, caractérisé en ce que l'agencement de synchronisation détermine en outre un troisième instant, qui correspond à un régime établi d'excitation à la fréquence nominale, en ce qu'il comprend aussi des moyens pour échantillonner le signal sortant du discriminateur à ce troisième instant, et en ce que les moyens pour fournir le signal d'erreur comportent un comparateur pour faire la différence entre l'amplitude du signal au deuxième instant et l'amplitude du signal au troisième instant.

9. Dispositif selon l'une quelconque des revendications 5 à 8, caractérisé en ce que les moyens pour ajuster le circuit résonnant sont des moyens pour commander la commutation de capacités, moyens qui sont constitués d'une mémoire dont le contenu est, soit incrémenté ou décrémenté à chaque échantillonnage selon le signe du signal issu du discrimina teur, soit laissé intact si la valeur absolue de ce signal est inférieure à une quantité prédéterminée, et en ce que, le contenu de la mémoire étant exprimé en numérotation binaire, chacun de ses bits commande la commutation d'une des capacités.

10. Dispositif selon l'une quelconque des revendications 5 à 9, incorporé dans un téléviseur, caractérisé en ce que l'agencement de synchronisation indique ledit premier instant une fois pendant chaque retour de trame.

FIG. 1

FIG. 2

FIG. 3

FIG. 4

FIG. 5

FIG. 6

FIG. 7

$E'_R - E'_Y$

$E'_B - E'_Y$

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | GB-A- 977 474 (COLLINS) * Page 1, ligne 18 - page 5, ligne 110; figures 1-3 * | 1 | H 03 J  7/02 |
| A,D | DE-A-2 702 565 (BOSCH) * Page 3, ligne 24 - page 6, ligne 5; figures 1,2 * | 5 | |

DOMAINES TECHNIQUES
RECHERCHES (Int. Cl.4)

H 03 J
H 04 N

Le présent rapport a été établi pour toutes les revendications

| Lieu de la recherche | Date d'achèvement de la recherche | Examinateur |
|---|---|---|
| LA HAYE | 23-12-1988 | DHONDT I.E.E. |

CATEGORIE DES DOCUMENTS CITES

X : particulièrement pertinent à lui seul
Y : particulièrement pertinent en combinaison avec un
  autre document de la même catégorie
A : arrière-plan technologique
O : divulgation non-écrite
P : document intercalaire

T : théorie ou principe à la base de l'invention
E : document de brevet antérieur, mais publié à la
  date de dépôt ou après cette date
D : cité dans la demande
L : cité pour d'autres raisons
.......................................................................................
& : membre de la même famille, document correspondant

EPO FORM 1503 03.82 (P0402)